(19) Europäisches Patentamt / European Patent Office / Office européen des brevets

(11) **EP 4 105 670 B1**

(12) **FASCICULE DE BREVET EUROPEEN**

(45) Date de publication et mention de la délivrance du brevet:
**25.10.2023 Bulletin 2023/43**

(21) Numéro de dépôt: **22178763.3**

(22) Date de dépôt: **13.06.2022**

(51) Classification Internationale des Brevets (IPC):
**G01R 31/50** $^{(2020.01)}$     **G01R 31/72** $^{(2020.01)}$
**G01R 31/62** $^{(2020.01)}$

(52) Classification Coopérative des Brevets (CPC):
**G01R 31/50; G01R 31/62; G01R 31/72**

(54) **DETECTION DE L'OUVERTURE D'UN TRANSFORMATEUR EXTERNE**

DETEKTION DER ÖFFNUNG EINES EXTERNEN TRANSFORMATORS

DETECTION OF THE OPENING OF AN EXTERNAL TRANSFORMER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.06.2021 FR 2106371**

(43) Date de publication de la demande:
**21.12.2022 Bulletin 2022/51**

(73) Titulaire: **SAGEMCOM ENERGY & TELECOM SAS**
**92500 Rueil-Malmaison (FR)**

(72) Inventeurs:
• **TEBOULLE, Henri**
**92500 RUEIL MALMAISON (FR)**

• **JEANROT, Marc**
**92500 RUEIL MALMAISON (FR)**
• **SOTIERE, Julien**
**92500 RUEIL MALMAISON (FR)**

(74) Mandataire: **Lavaud, Thomas**
**Cabinet Boettcher**
**5, rue de Vienne**
**75008 Paris (FR)**

(56) Documents cités:
**EP-A1- 3 561 523    US-A1- 2013 057 307**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

L'invention concerne le domaine des compteurs électriques, et notamment des compteurs destinés à des applications industrielles.

ARRIERE PLAN DE L'INVENTION

Les compteurs électriques destinés à un usage industriel peuvent mesurer des courants d'intensité très importante, jusqu'à 2000A typiquement.

Un tel compteur, par exemple un compteur triphasé, est classiquement connecté aux phases du réseau de distribution via des transformateurs externes montés sur les phases. Ces transformateurs externes présentent un rapport de transformation égal à 2000 typiquement.

Il semble très intéressant de pouvoir détecter l'ouverture d'un circuit de transformateur externe, sans intervention d'un opérateur, afin de prévenir rapidement et à moindre coût le client et/ou le distributeur d'énergie de la survenue d'une panne. Les documents EP3561523A1 et US2013/057307A1 divulguent un état de la technique pertinent.

OBJET DE L'INVENTION

L'invention a pour objet de détecter l'ouverture d'un transformateur externe relié à un compteur, de manière simple, peu coûteuse, fiable et robuste, et sans intervention d'un opérateur.

RESUME DE L'INVENTION

En vue de la réalisation de ce but, on propose un compteur électrique comportant :

- un circuit frontal agencé pour être relié à un transformateur de courant externe situé à l'extérieur du compteur et monté sur une phase d'un réseau de distribution ;
- un conducteur agencé pour être relié au transformateur de courant externe via le circuit frontal ;
- un circuit de test comprenant une chaîne de génération de test ayant une sortie reliée au conducteur, une chaîne de mesure de test ayant une entrée reliée au conducteur, et un composant de traitement ;

la chaîne de génération de test comprenant un générateur de tension et étant agencée pour appliquer une tension de test sur le conducteur, la tension de test produisant un courant de test circulant dans la chaîne de mesure de test et ladite tension de test ayant un niveau qui dépend d'une impédance équivalente du circuit frontal et du transformateur de courant externe, la chaîne de mesure de test étant agencée pour mesurer le niveau de la tension de test, le composant de traitement étant agencé pour acquérir le niveau de la tension de test et pour détecter une coupure du transformateur de courant externe lorsque le niveau de la tension de test est supérieur à un seuil de détection prédéfini.

Ainsi, en appliquant la tension de test sur le conducteur qui est relié au transformateur de courant externe via le circuit frontal, on produit un courant de test qui circule dans la chaîne de mesure de test. Le niveau de ladite tension de test dépend de l'impédance du transformateur de courant externe. La comparaison du niveau de ladite tension de test avec le seuil de détection prédéfini permet donc de détecter si le transformateur de courant externe est ouvert ou non.

L'invention fournit ainsi un critère de détection très fiable et très robuste, qui permet de détecter une coupure du transformateur externe sans intervention d'un opérateur. L'invention est peu complexe à mettre en oeuvre et peu coûteuse, puisqu'elle nécessite uniquement d'intégrer dans le compteur un circuit de test relativement simple.

On propose de plus un compteur électrique tel que précédemment décrit, dans lequel le circuit frontal comporte un transformateur de courant interne agencé pour être relié au transformateur de courant externe.

On propose de plus un compteur électrique tel que précédemment décrit, comportant en outre une chaîne de mesure principale ayant une entrée reliée au conducteur, la chaîne de mesure principale étant agencée de sorte qu'un courant de mesure principal, image d'un courant de phase circulant sur la phase, circule dans la chaîne de mesure principale, le composant de traitement étant agencé pour acquérir un niveau du courant de mesure principal, pour le comparer avec un seuil de test prédéfini, et pour commander la chaîne de génération de test de sorte que celle-ci applique la tension de test sur le conducteur lorsque le niveau du courant de mesure principal est inférieur au seuil de test prédéfini.

On propose de plus un compteur électrique tel que précédemment décrit, le composant de traitement comprenant une entrée de test appartenant à la chaîne de mesure de test et une entrée principale appartenant à la chaîne de mesure principale, l'entrée de test et l'entrée principale étant reliées à un même convertisseur analogique numérique intégré dans le composant de traitement.

On propose de plus un compteur électrique tel que précédemment décrit, la chaîne de génération de test comprenant un premier interrupteur situé entre le conducteur et le générateur de tension, le composant de traitement étant agencé pour fermer le premier interrupteur pour que la chaîne de génération de test applique la tension de test sur le conducteur.

On propose de plus un compteur électrique tel que précédemment décrit, la chaîne de mesure de test comprenant un deuxième interrupteur relié au conducteur et une chaîne de détection située en aval du deuxième interrupteur, le composant de traitement étant agencé pour fermer le deuxième interrupteur pour que le courant de test circule dans la chaîne de mesure de test.

On propose de plus un compteur électrique tel que précédemment décrit, la chaîne de détection comprenant successivement, d'amont en aval, un filtre passe-haut, un détecteur d'enveloppe, un convertisseur analogique numérique et un filtre passe-bas numérique.

On propose de plus un compteur électrique tel que précédemment décrit, le compteur électrique étant un compteur multiphasé comprenant une pluralité de circuits frontaux, chaque circuit frontal étant agencé pour être relié à un transformateur de courant externe situé à l'extérieur du compteur et monté sur l'une des phases d'un réseau de distribution multiphasé.

On propose de plus un compteur électrique tel que précédemment décrit, la chaîne de génération de test comprenant un unique générateur de tension et plusieurs premiers interrupteurs, chaque premier interrupteur étant relié à l'un des circuits frontaux.

On propose de plus un compteur électrique tel que précédemment décrit, la chaîne de mesure de test comprenant une unique chaîne de détection et plusieurs deuxièmes interrupteurs, chaque deuxième interrupteur étant relié à l'un des circuits frontaux.

On propose de plus un procédé de test, mis en oeuvre dans le composant de traitement d'un compteur électrique tel que précédemment décrit, et comprenant les étapes de :

- faire appliquer, par la chaîne de génération de test, la tension de test sur le conducteur ;
- acquérir le niveau de la tension de test via la chaîne de mesure de test ;
- détecter une coupure du transformateur de courant externe lorsque le niveau de la tension de test est supérieur à un seuil de détection prédéfini.

On propose de plus un programme d'ordinateur comprenant des instructions qui conduisent le composant de traitement du compteur électrique tel que précédemment décrit à exécuter les étapes du procédé de test tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés parmi lesquels :

[Fig. 1] la figure 1 représente un compteur électrique triphasé selon l'invention relié à des transformateurs externes montés sur les phases d'un réseau de distribution, dans une configuration à quatre fils ;
[Fig. 2] la figure 2 représente un schéma électrique du compteur selon l'invention ;

[Fig. 3] la figure 3 est une figure similaire à la figure 1, dans une configuration à trois fils.

DESCRIPTION DETAILLEE DE L'INVENTION

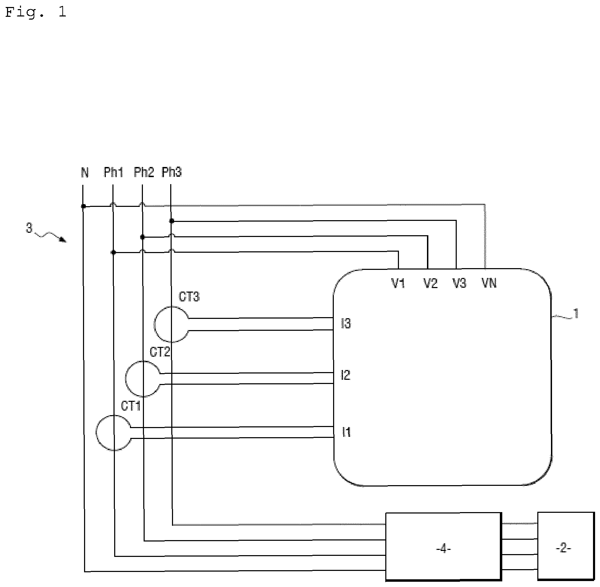

En référence à la figure 1, le compteur électrique selon l'invention 1 est ici un compteur triphasé qui est destiné à mesurer l'énergie électrique fournie à l'installation 2 d'un abonné par un réseau de distribution 3. Cette installation 2 est une installation industrielle.

Le réseau de distribution 3 comprend ici trois phases Ph1, Ph2, Ph3 et un neutre N (configuration à quatre fils). Un disjoncteur 4 est positionné « à la frontière » entre le réseau de distribution 3 et l'installation 2. Les trois phases Ph1, Ph2, Ph3 et le neutre N rentrent dans le disjoncteur 4 et en ressortent vers l'installation 2. Le disjoncteur 4 permet de couper la distribution d'énergie électrique.

Le compteur 1 comprend quatre entrées de tension V1, V2, V3, VN et trois entrées de courant I1, I2, I3 (chaque entrée de courant comprenant deux ports).

L'entrée de tension V1 est reliée à la phase Ph1, l'entrée de tension V2 est reliée à la phase Ph2, l'entrée de tension V3 est reliée à la phase Ph3 et l'entrée de tension VN au neutre N.

L'entrée de courant I1 est reliée à un transformateur de courant externe CT1 monté sur la phase Ph1, l'entrée de courant I2 est reliée à un transformateur de courant externe CT2 monté sur la phase Ph2, et l'entrée de courant I3 est reliée à un transformateur de courant externe CT3 monté sur la phase Ph3. Les transformateurs de courant externes sont situés à l'extérieur du compteur 1.

Chaque transformateur de courant externe présente ici un rapport de transformation égal à 2000.

Le compteur 1 récupère une image des courants de phase circulant sur les phases Ph1, Ph2 et Ph3 grâce aux transformateurs externes CT1, CT2 et CT3, ainsi que les tensions sur les entrées de tension V1, V2 et V3, pour réaliser les mesures métrologiques.

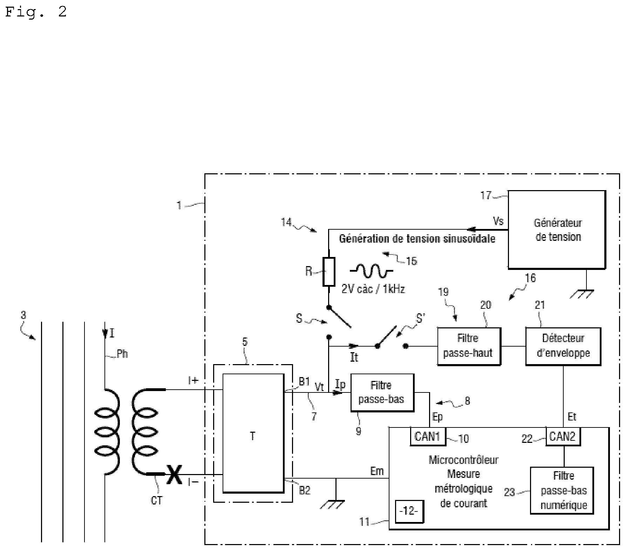

En référence à la figure 2, pour chaque transformateur de courant externe CT (et donc pour chaque entrée de courant comprenant deux ports I+ et I-), le compteur 1 comprend un circuit frontal 5 qui est relié audit transformateur externe CT.

Le circuit frontal 5 comprend ici un transformateur de courant interne T qui est relié au transformateur de courant externe CT. Plus précisément, les deux bornes du primaire du transformateur interne T sont reliées aux deux bornes du secondaire du transformateur externe CT. Le transformateur interne T est un transformateur torique ferromagnétique.

Le transformateur interne T présente ici un rapport de transformation égal à 1.

Le compteur 1 comporte un conducteur 7 qui est relié au transformateur externe CT via le circuit frontal 5. Le conducteur 7 est relié à une première borne B1 du secondaire du transformateur interne T.

Le compteur 1 comporte de plus une chaîne de mesure principale 8.

L'entrée de la chaîne de mesure principale 8 est reliée au conducteur 7.

Un courant de mesure principal Ip circule dans la chaîne de mesure principale 8. Le courant de mesure principal Ip est une image représentative du courant de phase I qui circule sur la phase Ph sur laquelle est monté le transformateur externe CT. La chaîne de mesure principale 8 est destinée, en opération, à mesurer le courant de mesure principal Ip pour évaluer le courant de phase I.

La chaîne de mesure principale 8 comprend, d'amont en aval, un filtre passe-bas 9, un premier convertisseur analogique numérique (CAN) 10, et un composant de traitement 11. Ici, par « en amont », on entend du côté du réseau de distribution 3, et par « en aval », on entend du côté de la mesure.

Le composant de traitement 11 est ici un microcontrôleur.

Le premier CAN 10 est ici intégré dans le microcontrôleur 11.

Le filtre passe-bas 9 est un filtre actif (de fréquence de coupure égale par exemple à 5kHz) intégrant un gain (égal par exemple à 1). Le filtre passe-bas 9 permet d'éliminer les bruits parasites, internes au compteur 1 ou venant du réseau de distribution 3, qui sont susceptibles de dégrader la mesure du courant de mesure principal Ip (et donc l'évaluation du courant de phase I).

Le microcontrôleur 11 est adapté à exécuter des instructions d'un programme pour mettre en oeuvre le procédé de test qui va être décrit. Le programme est stocké dans une mémoire 12, qui est intégrée dans ou reliée au microcontrôleur 11.

Le filtre passe-bas 9 a une entrée reliée à l'entrée de la chaîne de mesure principale 8 (et donc au conducteur 7 et à la première borne B1 du secondaire du transformateur interne T), et une sortie reliée à une entrée principale Ep du microcontrôleur 11. L'entrée principale Ep est connectée en interne au premier CAN 10.

Le filtre passe-bas 9 intègre une résistance de mesure (non représentée), qui a une borne reliée au conducteur 7 et une borne reliée à la masse.

Cette résistance de mesure permet de transformer le courant de mesure principal Ip en une tension image du courant de mesure principal Ip, qui est filtrée par le filtre passe-bas 9 et appliquée sur l'entrée Ep.

Le premier CAN 10 du microcontrôleur 11 produit donc des mesures numériques de la tension image et donc du courant de mesure principal Ip circulant dans la chaîne de mesure principale 8.

La deuxième borne B2 du secondaire du transformateur interne T est reliée à la masse et à une entrée de masse Em du microcontrôleur 11.

Le compteur 1 comporte de plus un circuit de test 14 comprenant une chaîne de génération de test 15, une chaîne de mesure de test 16 et le microcontrôleur 11. Le microcontrôleur 11 appartient donc ici à la fois à la chaîne de mesure principale 8 et au circuit de test 14.

La sortie de la chaîne de génération de test 15 est reliée au conducteur 7.

La chaîne de génération de test 15 comprend, d'amont en aval, un premier interrupteur S, une résistance R et un générateur de tension 17. Le premier interrupteur S est donc situé entre le conducteur 7 et le générateur de tension 17.

Le générateur de tension 17 produit une tension de sortie Vs, par exemple une tension sinusoïdale de 2V crête à crête avec une fréquence de 1kHz.

La résistance R a une valeur de résistance égale à 500kΩ.

La sortie du générateur de tension 17 est reliée à une première borne de la résistance R. Une deuxième borne de la résistance R est reliée à la borne du premier interrupteur S qui n'est pas reliée à la sortie de la chaîne de génération de test 15.

L'entrée de la chaîne de mesure de test 16 est reliée au conducteur 7, et donc à la sortie de la chaîne de génération de test 15.

La chaîne de mesure de test 16 comprend, d'amont en aval, un deuxième interrupteur S' et une chaîne de détection 19. Le deuxième interrupteur S' a une borne reliée à l'entrée de la chaîne de mesure de test 16 et une borne reliée à la chaîne de détection 19.

La chaîne de détection 19 comprend, d'amont en aval, un filtre passe-haut 20, un détecteur d'enveloppe 21, un deuxième CAN 22 et un filtre passe-bas numérique 23. Le deuxième CAN 22 est intégré dans le microcontrôleur 11. Le filtre passe-bas numérique 23 est programmé dans le microcontrôleur 11.

Ici, le filtre passe-haut 20 est un filtre actif (de fréquence de coupure par exemple égale à 500Hz) intégrant un gain (par exemple égal à 1).

Le filtre passe-haut 20 et le détecteur d'enveloppe 21 sont montés en série. Une sortie du détecteur d'enveloppe 21 est reliée à une entrée de test Et du microcontrôleur 11. Cette entrée de test Et est connectée en interne au deuxième CAN 22.

Le filtre passe-bas 23 acquiert les mesures numériques produites par le deuxième CAN 22. Le filtre passe-bas 23 a ici un gain égal à 1 et une fréquence de coupure de 10Hz.

Le premier interrupteur S et le deuxième interrupteur S' sont pilotés par le microcontrôleur 11.

Le premier interrupteur S permet de commander l'application de la tension de test Vt sur le conducteur 7.

Par défaut, le premier interrupteur S est à l'état ouvert, de sorte qu'aucune tension n'est appliquée par la chaîne de génération de test 15 sur le conducteur 7 et donc sur le secondaire du transformateur interne T.

Le deuxième interrupteur S' permet de sélectivement connecter ou déconnecter la chaîne de mesure de test 16 du conducteur 7, et donc du secondaire du transformateur interne T et de la chaîne de mesure principale 8. Le deuxième interrupteur S' se trouve par défaut à l'état ouvert.

Pour détecter si le transformateur externe CT est ouvert (coupure), le microcontrôleur 11 acquiert tout d'abord un niveau Np du courant de mesure principal Ip (qui est mesuré par la chaîne de mesure principale 8), et compare le niveau Np avec un seuil de test prédéfini St. Le niveau Np est par exemple une valeur efficace du courant de mesure principal Ip.

Lorsque le niveau Np est inférieur au seuil de test prédéfini, c'est-à-dire lorsque :

$$Np < St,$$

le microcontrôleur 11 ferme le premier interrupteur S et le deuxième interrupteur S'. Le premier interrupteur S et le deuxième interrupteur S' peuvent être fermés simultanément, ou bien l'un après l'autre. Les deux interrupteurs sont maintenus fermés le temps de la mesure.

En fermant le premier interrupteur S, le microcontrôleur 11 commande la chaîne de génération de test 15 de sorte que celle-ci génère la tension de test Vt sur le conducteur 7. La tension de test Vt résulte de la tension de sortie Vs.

L'application de la tension de test Vt génère des courants qui circulent dans les différentes branches reliées au conducteur 7. L'application de la tension de test Vt produit notamment un courant de test It qui circule dans la chaîne de mesure de test 16.

Le niveau de la tension de test Vt dépend des impédances équivalentes des différentes branches reliées au conducteur 7 et donc, notamment, de l'impédance équivalente du circuit frontal 5 et du transformateur externe CT.

Lorsque le transformateur externe CT est coupé, l'impédance équivalente du circuit frontal 5 et du transformateur externe CT est plus élevée : la tension de test Vt augmente.

La chaîne de mesure de test 16 mesure donc le niveau Nt de la tension de test Vt.

Le microcontrôleur 11 acquiert le niveau Nt de la tension de test Vt (en sortie du filtre passe-bas numérique 23) et le compare avec un seuil de détection prédéfini Sd.

Si le niveau Nt de la tension de test Vt est supérieur au seuil de détection prédéfini, c'est-à-dire si :

$$Nt > Sd,$$

alors le microcontrôleur 11 détecte une ouverture du transformateur externe CT.

Le seuil de détection prédéfini Sd est typiquement égal à 0,75V.

Dans le cas contraire, le microcontrôleur 11 détecte une absence de coupure du transformateur externe CT.

Le filtre passe-haut 20 et le détecteur d'enveloppe 21 permettent d'une part d'éliminer le 50Hz et les éventuelles perturbations venant du réseau de distribution 3, et d'autre part de présenter au deuxième CAN 22 un signal quasi continu qui est filtré (en numérique) par le filtre passe-bas 23.

La tension de test Vt est générée pendant une durée déterminée D, avec par exemple :

$$D = 1s.$$

La mesure est répétée à intervalles réguliers prédéterminés T, avec par exemple :

$$T = 10mn,$$

et ce, tant que Np < St.

Lorsque le compteur 1 détecte une coupure du transformateur externe CT, le compteur 1 produit une alarme et la transmet au distributeur et/ou au client, via des moyens de communication classiques : filaires ou non filaires, radio, par courants porteurs en ligne, etc.

On note qu'il est avantageux de calibrer en usine la tension de sortie Vs de 2V crête à crête à 1kHz produite par le générateur de tension 17, pour ajuster les mesures en régime permanent de manière à avoir un comportement adéquat des niveaux par rapport au seuil de détection prédéfini Sd.

L'injection de la tension de test Vt calibrée, d'un niveau significatif, entre les deux bornes du secondaire du transformateur interne T, permet donc de détecter une modification de l'impédance équivalente entre lesdites deux bornes. On construit ainsi un critère très robuste de détection de coupure du transformateur externe CT. La fréquence de 1kHz est suffisamment éloignée de la fréquence du réseau 3 pour assurer que la détection n'est pas polluée par ladite fréquence du réseau 3.

On note que les filtres actifs sont du 1er ordre et que les gains statiques des filtres sont adaptés afin d'éviter des saturations au niveau des CANs, et de manière à appliquer en entrée des CANs des signaux ayant des niveaux significatifs (et correspondant aux plages d'entrée des CANs).

Comme on l'a vu, le compteur 1 est un compteur multiphasé, triphasé en l'occurrence. Le principe de l'invention qui vient d'être décrit s'applique pour les trois phases du compteur 1.

Le compteur 1 comprend ainsi trois circuits frontaux 5 (un par phase) agencés chacun pour être relié à l'un des transformateurs de courant externe CT1, CT2, CT3.

Le circuit de test 14 comprend un unique composant de traitement (le microcontrôleur 11).

La chaîne de génération de test 15 comprend un unique générateur de tension 17 et plusieurs premiers interrupteurs S1, S2, S3 (un par phase), chaque premier interrupteur étant relié à l'un des circuits frontaux 5.

Les trois premiers interrupteurs S1, S2, S3 sont pilotés par le microcontrôleur 11.

De même, la chaîne de mesure de test 16 comprend une unique chaîne de détection 19 et plusieurs deuxièmes interrupteurs S'1, S'2, S'3 (un par phase), chaque deuxième interrupteur étant relié à l'un des circuits frontaux 5.

Un seul des trois premiers interrupteurs peut être fermé à un moment donné, pour injecter la tension de test Vt sur une seule phase. De même, un seul des trois deuxièmes interrupteurs peut être fermé à un moment donné, pour sélectionner la phase sur laquelle doit être réalisée la mesure. Pour une phase donnée Phi (i allant de 1 à 3), la mesure est réalisée lorsque les deux interrupteurs Si, S'i associés à ladite phase sont tous deux fermés et que tous les autres interrupteurs sont ouverts.

On note qu'en option, on peut avoir un transformateur externe monté sur le neutre N et relié à une quatrième entrée de courant IN du compteur 1. L'invention est alors mise en œuvre de la même manière pour détecter une ouverture du transformateur de courant externe sur le neutre.

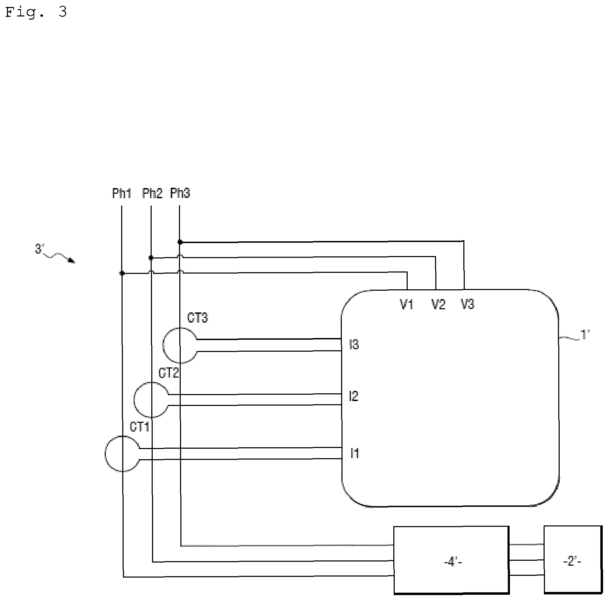

Sur la figure 3, le compteur électrique selon l'invention 1' est à nouveau un compteur triphasé qui est destiné à mesurer l'énergie électrique fournie à l'installation 2' d'un abonné par un réseau de distribution 3' (via un disjoncteur 4'). L'installation 2' est à nouveau une installation industrielle.

Cette fois, le réseau de distribution 3' comprend trois phases Ph1, Ph2, Ph3 uniquement (pas de neutre), et le compteur ne comprend que trois entrées de tension V1, V2, V3 (ainsi que trois entrées de courant I1, I2, I3). Les transformateurs externes CT1, CT2, CT3 sont installés sur les phases Ph1, Ph2, Ph3. Le compteur 1' comprend un circuit de test (intégrant une chaîne de génération de test et une chaîne de mesure de test) structurellement semblable à celui du compteur 1 et fonctionnant de la même manière.

Bien entendu, l'invention n'est pas limitée au mode de réalisation décrit mais englobe toute variante entrant dans le champ de l'invention.

L'invention peut être mise en œuvre avec un compteur électrique monophasé, ou bien multiphasé et relié à un nombre de phases quelconque.

L'architecture du compteur pourrait bien sûr être différente de celle décrite ici.

On a décrit ici que le microcontrôleur 11 appartient à la fois à la chaîne de mesure principale et au circuit de test. On pourrait cependant avoir un premier microcontrôleur intégrant un premier CAN et dédié à la chaîne de mesure principale, et un deuxième microcontrôleur intégrant un deuxième CAN et dédié au circuit de test.

De même, il est possible d'utiliser un unique CAN intégré dans un microcontrôleur et appartenant à la fois à la chaîne de mesure principale et à la chaîne de mesure de test. Le microcontrôleur comprend alors une entrée principale appartenant à la chaîne de mesure principale et une entrée de test appartenant à la chaîne de mesure de test. L'entrée de test et l'entrée principale sont reliées au CAN, qui intègre un multiplexeur ayant (au moins) deux entrées reliées respectivement à l'entrée de test et à l'entrée principale, ainsi qu'une sortie reliée au cœur de conversion du CAN.

Le ou les CANs peuvent aussi être un ou des CANs externes au microcontrôleur.

Le filtre passe-bas de la chaîne de mesure principale, tout comme le filtre passe-haut et le détecteur d'enveloppe de la chaîne de mesure de test, pourraient être des composants logiciels programmés dans le microcontrôleur ; dans ce cas, le ou les CANs sont positionnés en amont de ces modules.

Le composant de traitement n'est pas nécessairement un microcontrôleur, mais pourrait être un composant différent, et par exemple un processeur classique, un DSP (pour *Digital Signal Processor,* que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit*).

Le circuit frontal ne comprend pas nécessairement un transformateur de courant interne, mais peut comprendre des composants quelconques, voire même seulement des éléments conducteurs reliant respectivement le conducteur 7 et la masse aux ports I+ et I-.

## Revendications

1. Compteur électrique (1, 1') comportant :

   - un circuit frontal (5) agencé pour être relié à un transformateur de courant externe (CT) situé à l'extérieur du compteur et monté sur une phase (Ph) d'un réseau de distribution (3, 3') ;
   - un conducteur (7) agencé pour être relié au transformateur de courant externe via le circuit frontal ;
   - un circuit de test (14) comprenant une chaîne de génération de test (15) ayant une sortie reliée au conducteur (7), une chaîne de mesure de test (16) ayant une entrée reliée au conducteur, et un composant de traitement (11) ;

   la chaîne de génération de test comprenant un générateur de tension (17) et étant agencée pour appliquer une tension de test (Vt) sur le conducteur, la tension de test produisant un courant de test (It) circulant dans la chaîne de mesure de test et ladite tension de test ayant un niveau qui dépend d'une impédance équivalente du circuit frontal et du transformateur de courant externe, la chaîne de mesure de test étant agencée pour mesurer le niveau de la tension de test, le composant de traitement (11) étant agencé pour acquérir le niveau de la tension de test et pour détecter une coupure du transformateur de courant externe lorsque le niveau de la tension de test est supérieur à un seuil de détection prédéfini.

2. Compteur électrique selon la revendication 1, dans lequel le circuit frontal (5) comporte un transformateur de courant interne (T) agencé pour être relié au transformateur de courant externe (CT).

3. Compteur électrique selon l'une des revendications précédentes, comportant en outre une chaîne de mesure principale (8) ayant une entrée reliée au conducteur (7), la chaîne de mesure principale étant agencée de sorte qu'un courant de mesure principal (Ip), image d'un courant de phase (I) circulant sur la phase (Ph), circule dans la chaîne de mesure principale, le composant de traitement (11) étant agencé pour acquérir un niveau du courant de mesure principal, pour le comparer avec un seuil de test prédéfini, et pour commander la chaîne de génération de test (15) de sorte que celle-ci applique la tension de test (Vt) sur le conducteur lorsque le niveau du courant de mesure principal est inférieur au seuil de test prédéfini.

4. Compteur électrique selon la revendication 3, le composant de traitement comprenant une entrée de test appartenant à la chaîne de mesure de test et une entrée principale appartenant à la chaîne de mesure principale, l'entrée de test et l'entrée principale étant reliées à un même convertisseur analogique numérique intégré dans le composant de traitement.

5. Compteur électrique selon l'une des revendications précédentes, la chaîne de génération de test (15) comprenant un premier interrupteur (S) situé entre le conducteur (7) et le générateur de tension (17), le composant de traitement (11) étant agencé pour fermer le premier interrupteur (S) pour que la chaîne de génération de test applique la tension de test (Vt) sur le conducteur (7).

6. Compteur électrique selon l'une des revendications précédentes, la chaîne de mesure de test (16) comprenant un deuxième interrupteur (S') relié au conducteur (7) et une chaîne de détection (19) située en aval du deuxième interrupteur, le composant de traitement étant agencé pour fermer le deuxième interrupteur (S') pour que le courant de test circule dans la chaîne de mesure de test.

7. Compteur électrique selon la revendication 6, la chaîne de détection (19) comprenant successivement, d'amont en aval, un filtre passe-haut (20), un détecteur d'enveloppe (21), un convertisseur analogique numérique (22) et un filtre passe-bas numérique (23).

8. Compteur électrique selon l'une des revendications précédentes, le compteur électrique étant un compteur multiphasé comprenant une pluralité de circuits frontaux (5), chaque circuit frontal (5) étant agencé pour être relié à un transformateur de courant externe (CT) situé à l'extérieur du compteur et monté sur l'une des phases d'un réseau de distribution multiphasé.

9. Compteur électrique selon la revendication 5 et la revendication 8, la chaîne de génération de test (15) comprenant un unique générateur de tension (17) et plusieurs premiers interrupteurs (S), chaque premier interrupteur (S) étant relié à l'un des circuits frontaux.

10. Compteur électrique selon la revendication 6 et la revendication 8, la chaîne de mesure de test (16) comprenant une unique chaîne de détection (19) et plusieurs deuxièmes interrupteurs (S'), chaque deuxième interrupteur étant relié à l'un des circuits frontaux.

11. Procédé de test, mis en oeuvre dans le composant de traitement (11) d'un compteur électrique (1, 1') selon l'une des revendications précédentes, et comprenant les étapes de :

    - faire appliquer, par la chaîne de génération de test (15), la tension de test (Vt) sur le conducteur (7) ;
    - acquérir le niveau de la tension de test via la chaîne de mesure de test (16) ;
    - détecter une coupure du transformateur de courant externe (CT) lorsque le niveau de la tension de test est supérieur à un seuil de détection prédéfini.

12. Programme d'ordinateur comprenant des instructions qui conduisent le composant de traitement (11) du compteur électrique selon l'une des revendications 1 à 10 à exécuter les étapes du procédé de test selon la revendication 11.

13. Support d'enregistrement lisible par ordinateur, sur lequel est enregistré le programme d'ordinateur selon la revendication 12.

**Patentansprüche**

1. Stromzähler (1, 1'), umfassend:

    - eine Frontend-Schaltung (5), die ausgebildet ist, mit einem externen Stromtransformator (CT) verbunden zu werden, der sich außerhalb des Zählers befindet und auf einer Phase (Ph) eines Verteilungsnetzes (3, 3') angebracht ist;

- einen Leiter (7), der ausgebildet ist, mit dem externen Stromtransformator über die Frontend-Schaltung verbunden zu werden;
- eine Testschaltung (14), die eine Testerzeugungskette (15) umfasst, die einen Ausgang hat, der mit dem Leiter (7) verbunden ist, eine Testmesskette (16), die einen Eingang hat, der mit dem Leiter verbunden ist, und eine Verarbeitungskomponente (11);

wobei die Testerzeugungskette einen Spannungsgenerator (17) umfasst und ausgebildet ist, eine Testspannung (Vt) an dem Leiter anzulegen, wobei die Testspannung einen Teststrom (It) erzeugt, der in der Testmesskette fließt und wobei die genannte Testspannung eine Höhe hat, die von einer äquivalenten Impedanz der Frontend-Schaltung und des externen Stromtransformators abhängt, wobei die Testmesskette ausgebildet ist, die Höhe der Testspannung zu messen, wobei die Verarbeitungskomponente (11) ausgebildet ist, die Höhe der Testspannung zu erfassen und eine Trennung des externen Stromtransformators zu detektieren, wenn die Höhe der Testspannung größer als ein vordefinierter Detektionsschwellenwert ist.

2. Stromzähler nach Anspruch 1, bei dem die Frontend-Schaltung (5) einen internen Stromtransformator (T) umfasst, der ausgebildet ist, mit dem externen Stromtransformator (CT) verbunden zu werden.

3. Stromzähler nach einem der vorhergehenden Ansprüche, ferner umfassend eine Hauptmesskette (8), die einen Eingang hat, der mit dem Leiter (7) verbunden ist, wobei die Hauptmesskette derart ausgebildet ist, dass ein Hauptmessstrom (Ip), Bild eines Phasenstroms (I), der auf der Phase (Ph) fließt, in der Hauptmesskette fließt, wobei die Verarbeitungskomponente (11) ausgebildet ist, eine Höhe des Hauptmessstroms zu erfassen, um sie mit einem vordefinierten Testschwellenwert zu vergleichen, und die Testerzeugungskette (15) derart zu steuern, dass diese die Testspannung (Vt) an dem Leiter anlegt, wenn die Höhe des Hauptmessstroms niedriger als ein vordefinierter Testschwellenwert ist.

4. Stromzähler nach Anspruch 3, wobei die Verarbeitungskomponente einen Testeingang umfasst, der zur Testmesskette gehört, und einen Haupteingang, der zur Hauptmesskette gehört, wobei der Testeingang und der Haupteingang mit einem selben Analog-Digital-Wandler verbunden sind, der in die Verarbeitungskomponente integriert ist.

5. Stromzähler nach einem der vorhergehenden Ansprüche, wobei die Testerzeugungskette (15) einen ersten Unterbrecher (S) umfasst, der sich zwischen dem Leiter (7) und dem Spannungserzeuger (17) befindet, wobei die Verarbeitungskomponente (11) ausgebildet ist, den ersten Unterbrecher (S) zu schließen, damit die Testerzeugungskette die Testspannung (Vt) an dem Leiter (7) anlegt.

6. Stromzähler nach einem der vorhergehenden Ansprüche, wobei die Testmesskette (16) einen zweiten Unterbrecher (S') umfasst, der mit dem Leiter (7) verbunden ist, und eine Detektionskette (19), die sich stromabwärts des zweiten Unterbrechers befindet, wobei die Verarbeitungskomponente ausgebildet ist, den zweiten Unterbrecher (S') zu schließen, damit der Teststrom in der Testmesskette fließt.

7. Stromzähler nach Anspruch 6, wobei die Detektionskette (19) nacheinander, von stromaufwärts nach stromabwärts, ein Hochpassfilter (20), einen Hüllkurvendetektor (21), eine Analog-Digital-Wandler (22) und ein digitales Tiefpassfilter umfasst.

8. Stromzähler nach einem der vorhergehenden Ansprüche, wobei der Stromzähler ein mehrphasiger Zähler ist, der eine Vielzahl von Frontend-Schaltungen (5) umfasst, wobei jede Frontend-Schaltung (5) ausgebildet ist, mit einem externen Stromtransformator (CT) verbunden zu werden, der sich außerhalb des Zählers befindet und der auf einer der Phasen eines mehrphasigen Verteilungsnetzes angebracht ist.

9. Stromzähler nach Anspruch 5 und Anspruch 8, wobei die Testerzeugungskette (15) einen einzigen Spannungsgenerator (17) und mehrere erste Unterbrecher (S) umfasst, wobei jeder erste Unterbrecher (S) mit einer der Frontend-Schaltungen verbunden ist.

10. Stromzähler nach Anspruch 6 und Anspruch 8, wobei die Testmesskette (16) eine einzige Detektionskette (19) und mehrere zweite Unterbrecher (S') umfasst, wobei jeder zweite Unterbrecher mit einer der Frontend-Schaltungen verbunden ist.

11. Testverfahren, das in der Verarbeitungskomponente (11) eines Stromzählers (1, 1') nach einem der vorhergehenden Ansprüche durchgeführt wird und die Schritte umfasst:

- Veranlassen, dass durch die Testerzeugungskette (15) die Testspannung (Vt) an dem Leiter (7) angelegt wird;
- Erfassen der Höhe der Testspannung über die Testmesskette (16);
- Detektieren einer Trennung des externen Stromtransformators (CT), wenn die Höhe der Testspannung größer als ein vordefinierter Detektionsschwellenwert ist.

12. Computerprogramm, umfassend Anweisungen, die die Verarbeitungskomponente (11) des Stromzählers (1) nach einem der Ansprüche 1 bis 10 dazu veranlassen, die Schritte des Testverfahrens nach Anspruch 11 auszuführen.

13. Computerlesbarer Aufzeichnungsträger, auf dem das Computerprogramm nach Anspruch 12 gespeichert ist.

**Claims**

1. Electricity meter (1, 1') comprising:

   a front circuit (5) arranged to be connected to an external current transformer (CT) located outside of the electricity meter and mounted on a phase (Ph) of a distribution network (3, 3');
   a conductor (7) arranged to be connected to the external current transformer via the front circuit;
   a test circuit (14) comprising a test generation chain (15) having an output connected to the conductor (7), a test measuring chain (16) having an input connected to the conductor, and a processing component (11);

   the test generation chain comprising a voltage generator (17) and being arranged to apply a test voltage (Vt) on the conductor, the test voltage producing a test current (It) circulating in the test measuring chain and said test voltage having a level which depends on an equivalent impedance of the front circuit and of the external current transformer, the test measuring chain being arranged to measure the level of the test voltage, the processing component (11) being arranged to acquire the level of the test voltage and to detect a cutoff of the external current transformer when the level of the test voltage is greater than a predefined detection threshold.

2. Electricity meter according to claim 1, wherein the front circuit (5) comprises an internal current transformer (T) arranged to be connected to the external current transformer (CT).

3. Electricity meter according to one of the preceding claims, further comprising a main measuring chain (8) having an input connected to the conductor (7), the main measuring chain being arranged such that a main measuring current (Ip), image of a phase current (I) circulating over the phase (Ph), circulates in the main measuring chain, the processing component (11) being arranged to acquire a level of the main measuring current, to compare it with a predefined test threshold, and to control the test generation chain (15) such that this applies the test voltage (Vt) on the conductor when the level of the main measuring current is less than the predefined test threshold.

4. Electricity meter according to claim 3, the processing component comprising a test input belonging to the test measuring chain and a main input belonging to the main measuring chain, the test input and the main input being connected to one same analogue-to-digital converter integrated in the processing component.

5. Electricity meter according to one of the preceding claims, the test generation chain (15) comprising a first switch (S) located between the conductor (7) and the voltage generator (17), the processing component (11) being arranged to close the first switch (S) such that the test generation chain applies the test voltage (Vt) on the conductor (7).

6. Electricity meter according to one of the preceding claims, the test measuring chain (16) comprising a second switch (S') connected to the conductor (7) and a detection chain (19) located downstream from the second switch, the processing component being arranged to close the second switch (S') such that the test current circulates in the test measuring chain.

7. Electricity meter according to claim 6, the detection chain (19) successively comprising, from upstream to downstream, a high-pass filter (20), an envelope detector (21), an analogue-to-digital converter (22) and a digital low-pass filter (23).

8. Electricity meter according to one of the preceding claims, the electricity meter being a multiphase meter comprising a plurality of front circuit (5), each front circuit (5) being arranged to be connected to an external current transformer (CT) located outside of the meter and mounted on one of the phases of a multiphase distribution network.

9. Electricity meter according to claim 5 and claim 8, the test generation chain (15) comprising one single voltage generator (17) and several first switches (S), each first switch (S) being connected to one of the front circuits.

10. Electricity meter according to claim 6 and claim 8, the test measuring chain (16) comprising one single detection chain (19) and several second switches (S'), each second switch being connected to one of the front circuits.

11. Test method, implemented in the processing component (11) of an electricity meter (1, 1') according to one of the preceding claims, and comprising the steps of:

applying, by the test generation chain (15), the test voltage (Vt) on the conductor (7);
acquiring the level of the test voltage via the test measuring chain (16);
detecting a cutoff of the external current transformer (CT) when the level of the test voltage is greater than a predefined detection threshold.

12. Computer program comprising instructions which drive the processing component (11) of the electricity meter according to one of claims 1 to 10 to execute the steps of the test method according to claim 11.

13. Recording media which can be read by a computer, on which the computer program is recorded, according to claim 12.

Fig. 1

Fig. 2

Fig. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3561523 A1

- US 2013057307 A1